# EUROPÄISCHE PATENTANMELDUNG

(11) **EP 0 924 775 A1**
(43) Veröffentlichungstag der Anmeldung: **23.06.1999**
(21) Anmeldenummer: 98122879.4
(22) Anmeldetag: 02.12.1998
(51) Int. Cl.: H01L 31/048, H01L 31/042, H01L 27/142

(54) **Solarbatterie**

(30) Priorität: 20.12.1997 DE 19757070
(71) Anmelder: abac Elektronische Kommunikationseinrichtungen GmbH, 72762 Reutlingen (DE)
(72) Erfinder: Bidell, Martin, 72766 Reutlingen (DE)
(74) Vertreter: Möbus, Daniela, Dr.-Ing.

(57) **Zusammenfassung**

Bei der Solarbatterie mit einer Vielzahl zusammengeschalteter Solarzellen, weist ein Gehäuse die Form eines Teils einer Dachabdeckung eines Gebäudes auf.

## Beschreibung

Die Erfindung betrifft eine Solarbatterie mit einer Vielzahl zusammengeschalteter Solarzellen.

Bisher bekannte Solarbatterien sind als große Paneelen ausgeführt. Man setzt sie in der Regel für die elektrische Energieerzeugung auf Wohnhäusern oder Fabrikdächern ein. Die Montage der bisher bekannten Solarbatterien ist sehr aufwendig und verursacht damit entsprechend hohe Montagekosten. Kritisch ist die Abdichtung gegen Schmutz und Feuchtigkeit zwischen der Paneele und der Dachabdeckung. Für die Errichtung einer Solarbatterie muss bisher immer eine zeitraubende Baugenehmigung eingeholt werden. Außerdem stellt das Eigengewicht einer Solarbatterie eine große ungleichmäßig verteilte statische Last für den Dachstuhl dar.

Der Erfindung liegt die Aufgabe zugrunde, eine Einrichtung der eingangs genannten Art dahin gehend zu verbessern, dass die Montage einfach und kostengünstig durchzuführen ist und das Dichtungsproblem zwischen der Sonnenbatterie und der Dachabdeckung entfällt.

Die gestellte Aufgabe wird bei der Erfindung dadurch gelöst, dass sie ein Gehäuse in der Form eines Teils einer Dachabdeckung eines Gebäudes aufweist. Das Gehäuse kann beispielsweise die Form eines oder mehrerer sich überlappender Dachziegel oder die Form eines Wellblechdachausschnittes aufweisen. Durch Austausch eines Teils der bisherigen Dachabdeckung kann die Solarbatterie rasch und bequem von jedem Bauherrn selbst montiert werden. Dadurch lässt sich die Solarbatterie auch relativ unauffällig in die übrige Dachabdeckung integrieren und die statische Last verteilt sich gleichmäßiger auf dem Dachstuhl. Die Solarbatterie kann mit einem elektrischen Anschlusskabel und einer Steckdose versehen sein. Dies ermöglicht ohne große Mühe und mit ausreichender Sicherheit für die eigene Person, die Solarbatterie an das Hausnetz anzuschließen. Die Solarbatterie kann einen Spannungswandler aufweisen. Dieser ermöglicht es, elektrische Verbraucher mit beispielsweise 220 V Wechselstrom zu versorgen. Um den Wirkungsgrad zu erhöhen, kann dem Spannungswandler eine Strombegrenzungsschaltung, beispielsweise die aus der DE 196 20 803.3 bekannte Schaltung vorgeschaltet sein. Zur einfacheren Handhabung kann der Spannungswandler im Gehäuse der Solarbatterie untergebracht sein.

## Patentansprüche

1. Solarbatterie mit einer Vielzahl zusammengeschalteter Solarzellen, dadurch gekennzeichnet, dass sie ein Gehäuse in der Form eines Teils einer Dachabdeckung eines Gebäudes aufweist.

2. Solarbatterie nach Anspruch 1, dadurch gekennzeichnet, dass das Gehäuse die Form eines oder mehrerer sich überlappender Dachziegel aufweist.

3. Solarbatterie nach Anspruch 1, dadurch gekennzeichnet, dass das Gehäuse die Form eines Wellblechdachausschnittes aufweist.

4. Solarbatterie nach einem der Ansprüche 1 bis 3, dadurch gekennzeichnet, dass sie mit einem elektrischen Anschlusskabel und einer Steckdose versehen ist.

5. Solarbatterie nach einem der Ansprüche 1 bis 4, dadurch gekennzeichnet, dass sie einen Spannungswandler aufweist.

6. Solarbatterie nach Anspruch 5, dadurch gekennzeichnet, dass dem Spannungswandler eine Strombegrenzungsschaltung vorgeschaltet ist.

7. Solarbatterie nach Anspruch 5 oder 6, dadurch gekennzeichnet, dass der Spannungswandler im Gehäuse der Solarbatterie untergebracht ist.
